(19) **Europäisches Patentamt / European Patent Office / Office européen des brevets**

(11) **EP 3 287 822 B1**

(12) **FASCICULE DE BREVET EUROPEEN**

(45) Date de publication et mention de la délivrance du brevet:
**13.03.2019 Bulletin 2019/11**

(51) Int Cl.:
**G02B 6/12** *(2006.01)*  **G02B 6/122** *(2006.01)*
**G02B 6/30** *(2006.01)*

(21) Numéro de dépôt: **17185641.2**

(22) Date de dépôt: **09.08.2017**

(54) **CIRCUIT PHOTONIQUE COMPORTANT UNE STRUCTURE DE COUPLAGE À UN DISPOSITIF EXTÉRIEUR**

PHOTONISCHER SCHALTKREIS MIT EINER STRUKTUR ZUR KOPPELUNG AN EINE EXTERNE VORRICHTUNG

PHOTONIC CIRCUIT COMPRISING A STRUCTURE TO COUPLE TO AN EXTERNAL DEVICE

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **26.08.2016 FR 1657975**

(43) Date de publication de la demande:
**28.02.2018 Bulletin 2018/09**

(73) Titulaire: **Commissariat à l'Energie Atomique et aux Energies Alternatives**
**75015 Paris (FR)**

(72) Inventeurs:
• **BOUTAMI, Salim**
**38100 GRENOBLE (FR)**
• **JANY, Christophe**
**38340 VOREPPE (FR)**

(74) Mandataire: **Cabinet Beaumont**
**4, Place Robert Schuman**
**B.P. 1529**
**38025 Grenoble Cedex 1 (FR)**

(56) Documents cités:
EP-A1- 3 206 062       JP-A- 2015 215 477
US-A1- 2012 170 889    US-A1- 2013 170 807
US-A1- 2015 010 266

• HATORI NOBUAKI ET AL: "A Hybrid Integrated Light Source on a Silicon Platform Using a Trident Spot-Size Converter", JOURNAL OF LIGHTWAVE TECHNOLOGY, IEEE SERVICE CENTER, NEW YORK, NY, US, vol. 32, no. 7, 1 avril 2014 (2014-04-01), pages 1329-1336, XP011540268, ISSN: 0733-8724, DOI: 10.1109/JLT.2014.2304305 [extrait le 2014-02-18]
• SISTO MARCO MICHELE ET AL: "Novel spot size converter for coupling standard single mode fibers to SOI waveguides", SPIE - INTERNATIONAL SOCIETY FOR OPTICAL ENGINEERING. PROCEEDINGS, S P I E - INTERNATIONAL SOCIETY FOR OPTICAL ENGINEERING, US, vol. 9752, 14 mars 2016 (2016-03-14), pages 975217-975217, XP060067697, ISSN: 0277-786X, DOI: 10.1117/12.2230739 ISBN: 978-1-5106-0753-8

**Description**

Domaine

La présente demande concerne le domaine des circuits optiques intégrés ou circuits photoniques, et vise plus particulièrement une structure de couplage d'un circuit photonique à un dispositif extérieur.

Exposé de l'art antérieur

Dans certaines applications, on peut être amené à vouloir coupler optiquement deux circuits photoniques distincts, c'est-à-dire réalisés sur des puces différentes. A titre d'exemple, on peut vouloir coupler une source laser intégrée sur une première puce photonique, par exemple réalisée à base de matériaux semiconducteurs III-V, à un circuit photonique passif intégré sur une deuxième puce, par exemple réalisée à base de silicium.

On trouve dans la littérature principalement deux méthodes permettant de coupler optiquement deux circuits photoniques, le couplage par onde évanescente et le couplage bout à bout.

Le couplage par onde évanescente consiste à superposer les deux circuits de façon à disposer, à une distance relativement faible mais non nulle, une portion d'un premier guide d'onde intégré dans le premier circuit, et une portion sensiblement parallèle (mais non coaxiale) d'un deuxième guide d'onde intégré dans le deuxième circuit. Les conditions à respecter pour réaliser un couplage par onde évanescente entre deux guides d'ondes sont par exemple décrites dans les articles intitulés "Electrically driven hybrid Si/III-V Fabry-Pérot lasers based on adiabatic mode transformers" de B. Ben Bakir et al., Opt Exp 19, 10317 (2011), et "Adiabaticity criterion and the shortest adiabatic mode transformer in a coupled-waveguide system" de X. Sun et al., Opt let 34, 280 (2009). Le couplage par onde évanescente permet, lorsqu'il est correctement réalisé, d'obtenir de bonnes performances de couplage, et en particulier de très faibles pertes d'énergie lumineuse lors du transfert du signal entre les deux circuits. Ce type de couplage nécessite toutefois de prendre des précautions particulières lors de l'assemblage des circuits, pour pouvoir contrôler avec précision la distance entre les deux portions parallèles de guides superposées et la qualité de l'interface entre les deux circuits. En pratique, ce type de couplage est donc relativement délicat à mettre en oeuvre.

Le couplage bout à bout ("butt coupling" en anglais) consiste à juxtaposer les deux circuits de façon à abouter, selon un même axe optique, une extrémité d'un premier guide d'onde intégré dans le premier circuit à une extrémité d'un deuxième guide d'onde intégré dans le deuxième circuit. Des exemples de systèmes optiques mettant en oeuvre un couplage bout à bout entre un circuit photonique et un dispositif extérieur sont par exemple décrits dans les articles intitulés "Diode-laser-to-waveguide butt coupling" de P. Karioja et al., Applied optics 35, 404 (1996), et "Efficient Silicon-on-Insulator Fiber Coupler Fabricated Using 248-nm-Deep UV Lithography" de G. Roelkens et al., Photonics technology letters 17, 2613 (2005). Le couplage bout à bout est largement utilisé, notamment dans le domaine des télécommunications, en raison de sa facilité de mise en oeuvre. Le couplage bout à bout présente toutefois l'inconvénient d'être relativement sensible aux erreurs d'alignement entre les deux guides, et donc de procurer des rendements de couplage incertains.

Le document US 2013/170807 au nom de Hatori Nobuaki et al. divulgue un circuit photonique comportant une structure de couplage à un dispositif extérieur, cette structure comportant

un guide d'onde principal et
deux guides d'ondes secondaires,
chaque guide secondaire ayant une première portion sensiblement parallèle au guide principal disposée au voisinage du guide principal de façon à réaliser un couplage par onde évanescente entre le guide principal et le guide secondaire,
la première portion se prolongeant par une deuxième portion dont une extrémité opposée à la première portion définit une face de couplage du guide secondaire, débouchant au niveau d'une face extérieure du circuit.

Il existe un besoin pour une structure de couplage d'un circuit photonique à un dispositif extérieur, cette structure palliant tout ou partie des inconvénients des structures connues.

Résumé

Ainsi, un mode de réalisation prévoit un circuit photonique comportant une structure de couplage à un dispositif extérieur, cette structure comportant un guide d'onde principal et quatre guides d'ondes secondaires, chaque guide secondaire ayant une première portion sensiblement parallèle au guide principal disposée au voisinage du guide principal de façon à réaliser un couplage par onde évanescente entre le guide principal et le guide secondaire, la première portion se prolongeant par une deuxième portion dont une extrémité opposée à la première portion définit une face de couplage du guide secondaire, débouchant au niveau d'une face extérieure du circuit, dans lequel les premières portions des quatre guides secondaires sont, en section transversale, disposées autour du guide principal sur les diagonales du guide principal.

Selon un mode de réalisation, chaque guide secondaire présente une terminaison en pointe du côté de sa face de couplage.

Selon un mode de réalisation, les coefficients de couplage entre le guide principal et chacun des guides secondaires sont sensiblement identiques.

Selon un mode de réalisation, les premières portions des guides secondaires sont sensiblement à égale distance du guide principal.

Selon un mode de réalisation, la distance centre à centre maximale entre deux guides secondaires au niveau de leurs faces de couplage est sensiblement égale à deux fois le rayon du faisceau lumineux propagé par chaque guide secondaire au niveau de sa face de couplage.

Selon un mode de réalisation, le long de leurs premières portions, les guides secondaires s'élargissent progressivement jusqu'à atteindre une largeur maximale au niveau de leurs deuxièmes portions.

Selon un mode de réalisation, le long des premières portions des guides secondaires, le guide principal s'affine progressivement.

Selon un mode de réalisation, le guide principal s'interrompt avant la face extérieure du circuit.

Selon un mode de réalisation, le guide d'onde principal et les guides d'ondes secondaires sont en silicium-germanium et sont entourés de silicium.

Selon un mode de réalisation, le guide d'onde principal et les guides d'ondes secondaires sont en silicium amorphe et sont entourés d'oxyde de silicium.

Selon un mode de réalisation, le guide d'onde principal forme un prolongement d'un guide d'onde interne au circuit, le guide d'onde interne étant en silicium cristallin.

Selon un mode de réalisation, le guide d'onde principal et les guides d'ondes secondaires sont en nitrure de silicium et sont entourés d'oxyde de silicium.

Selon un mode de réalisation, le circuit comprend en outre une source laser intégrée, le guide d'onde principal étant couplé à la source laser.

## Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :

les figures 1A et 1B illustrent un exemple comparatif, qui ne fait pas partie de l'invention, d'une structure de couplage d'un circuit photonique à un dispositif extérieur ;

les figures 2A, 2B, 2C, 2D illustrent un exemple d'un mode de réalisation d'une structure de couplage d'un circuit photonique à un dispositif extérieur, l'exemple ne faisant pas partie de l'invention ;

les figures 3A et 3B illustrent un avantage de la structure de couplage des figures 2A, 2B, 2C, 2D ;

la figure 4 illustre une réalisation de la structure de couplage selon l'invention, qui est une variante de la structure de couplage des figures 2A, 2B, 2C, 2D ;

les figures 5A, 5B, 5C, 5D, 5E, 5F, 5G, 5H, 5I illustrent des étapes d'un exemple de procédé de fabrication d'une structure de couplage du type décrit en relation avec la figure 4 ;

les figures 6A, 6B, 6C illustrent des étapes d'un autre exemple de procédé de fabrication d'une structure de couplage du type décrit en relation avec la figure 4 ; et

les figures 7A, 7B, 7C, 7D illustrent des étapes d'un autre exemple de procédé de fabrication d'une structure de couplage du type décrit en relation avec la figure 4.

## Description détaillée

De mêmes éléments ont été désignés par de mêmes références aux différentes figures et, de plus, les diverses figures ne sont pas tracées à l'échelle. Par souci de clarté, seuls les éléments qui sont utiles à la compréhension des modes de réalisation décrits ont été représentés et sont détaillés. En particulier, dans la description qui suit, seules des structures de couplage d'un circuit photonique à un dispositif extérieur sont détaillées. Les autres éléments que peut comporter un circuit photonique ne sont pas détaillés, les modes de réalisation décrits étant compatibles avec tous les composants usuels que l'on peut trouver dans un circuit photonique.

Dans la description qui suit, sauf indication contraire, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence à l'orientation des vues en coupe des figures, étant entendu que, dans la pratique, les structures décrites peuvent être orientées différemment. Sauf précision contraire, les expressions "approximativement", "sensiblement", et "de l'ordre de" signifient à 10 % près, de préférence à 5 % près, ou, lorsqu'elles se réfèrent à des dimensions ou orientations angulaires (horizontal, vertical, parallèle, orthogonal, etc.), à 10° près, de préférence à 5° près.

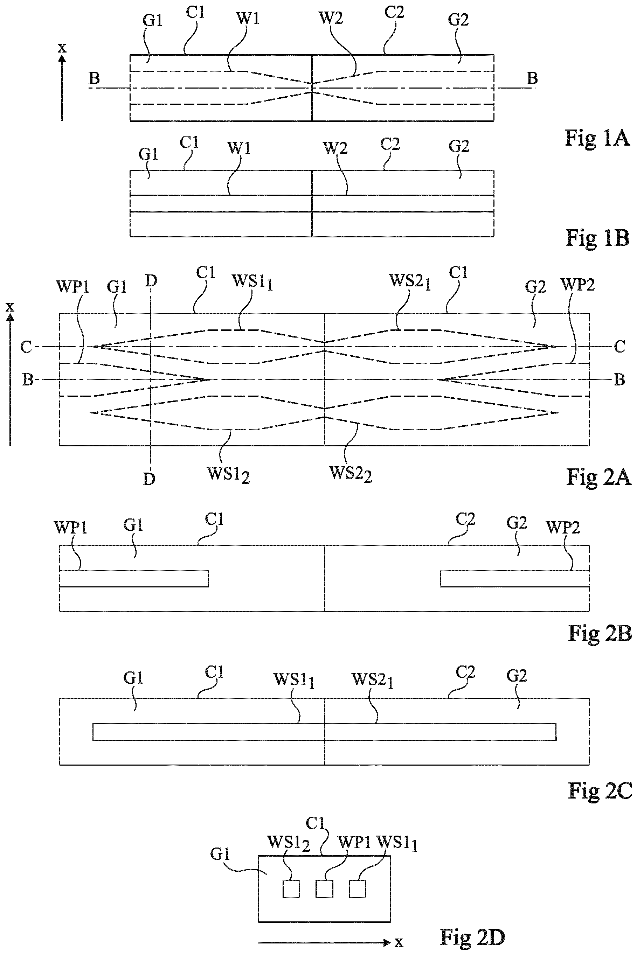

Les figures 1A et 1B illustrent un exemple comparatif, qui ne fait pas partie de l'invention, d'une structure de couplage d'un circuit photonique à un dispositif extérieur. Plus particulièrement, les figures 1A et 1B représentent un assemblage comportant deux circuits photoniques distincts C1 et C2 couplés optiquement. La figure 1A est une vue de dessus de l'assemblage, et la figure 1B est une vue en coupe longitudinale selon le plan B-B de la figure 1A.

Le circuit C1 comprend une structure de couplage à un dispositif extérieur comportant un guide d'onde W1 en forme de ruban, par exemple de section transversale rectangulaire. Le guide d'onde W1 est réalisé en un premier matériau transparent, et est entouré d'une gaine G1 en un deuxième matériau transparent d'indice de réfraction inférieur à celui du premier matériau. La gaine G1 est en contact avec toute la surface extérieure du guide W1 à l'exception de ses faces d'entrée/sortie, qui correspondent aux deux faces orthogonales à l'axe longitudinal du guide. Dans l'exemple représenté, l'axe longitudinal ou axe optique du guide d'onde W1 est sensiblement horizontal. Le guide d'onde W1 débouche au niveau d'une face latérale du circuit C1, c'est-à-dire que l'une de ses faces d'entrée/sortie, appelée face de couplage, forme une portion d'une face latérale du circuit C1. Du côté de sa face de couplage, le guide d'onde W1 présente une portion de terminaison en forme de pointe, c'est-à-dire dans laquelle sa largeur décroit progressivement jusqu'à atteindre une valeur minimale au niveau de la face de couplage. Dans cet exemple, le guide d'onde W1 présente une épaisseur sensiblement constante sur toute sa longueur.

Dans l'exemple représenté, le circuit C2 comprend une structure de couplage sensiblement symétrique, comportant un guide d'onde W2 en forme de ruban, dont une face de couplage débouche au niveau d'une face latérale du circuit C2, le guide W2 présentant une terminaison en pointe du côté de sa face de couplage, et étant entouré d'une gaine G2 en un matériau de plus faible indice de réfraction.

Le couplage entre les circuits C1 et C2 est un couplage bout à bout, c'est-à-dire que les circuits C1 et C2 sont juxtaposés de façon à accoler la face de couplage du guide d'onde W1 contre la face de couplage du guide d'onde W2, de façon que les axes optiques des guides W1 et W2 soient confondus au niveau de la zone de couplage.

La prévision d'une portion de terminaison en forme de pointe au niveau de la face de couplage a pour avantage d'améliorer la tolérance aux erreurs d'alignement par rapport à une structure de couplage à section transversale régulière. En effet, le guidage de la lumière dans la structure s'effectue par contraste d'indice entre la région W1 (respectivement W2), de plus haut indice, et la région G1 (respectivement G2), de plus bas indice. Lorsque la section du guide W1 (respectivement W2) s'affine progressivement jusqu'à disparaître, on tend vers une gaine infinie homogène, transportant une onde plane d'extension infinie. Pour une section de guide W1 (respectivement W2) réduite mais non nulle, on obtient donc un mode de propagation (ou surface du faisceau lumineux en section transversale) plus étendu. Il en résulte que pour une erreur d'alignement donnée, la diminution du coefficient de couplage liée au désalignement des guides W1 et W2 est réduite par rapport à une structure de couplage à section transversale régulière. Le coefficient ou taux de couplage est en effet lié à l'intégrale spatiale de recouvrement entre les deux modes, tenant compte du désalignement.

Une limitation est que pour réaliser un couplage efficace, la taille du mode de propagation de la lumière dans le guide W1 et la taille du mode de propagation de la lumière dans le guide W2 doivent de préférence être sensiblement identiques au niveau des faces de couplage des guides. En pratique, pour pouvoir contrôler la taille du mode au niveau de la face de couplage du guide, la largeur finale du guide à l'extrémité de la pointe doit rester suffisamment grande pour pouvoir être contrôlée précisément à la fabrication. Cette contrainte de reproductibilité constitue une limite à l'extension de mode accessible et donc à la tolérance aux erreurs d'alignement qui peut être atteinte.

Les figures 2A, 2B, 2C, 2D illustrent un exemple d'un mode de réalisation d'une structure de couplage d'un circuit photonique à un dispositif extérieur, l'exemple ne faisant pas partie de l'invention. Plus particulièrement, les figures 2A, 2B, 2C, 2D représentent un assemblage comportant deux circuits photoniques distincts C1 et C2 couplés optiquement. La figure 2A est une vue de dessus de l'assemblage, les figures 2B et 2C sont des vues en coupe longitudinales selon les plans B-B et C-C de la figure 2A, et la figure 2D est une vue en coupe transversale selon le plan D-D de la figure 2A.

Le circuit C1 comprend une structure de couplage à un dispositif extérieur comportant un guide d'onde principal WP1, par exemple couplé optiquement à un autre composant (non visible sur les figures) du circuit C1, et deux guides d'ondes secondaires $WS1_1$ et $WS1_2$, par exemple sensiblement identiques, non directement couplés à d'autres composants du circuit. Le guide d'onde principal WP1 et les guides d'ondes secondaires $WS1_1$ et $WS1_2$ sont par exemple en forme de rubans, par exemple rectilignes, par exemple à sections transversales rectangulaires (par exemple carrées). Dans cet exemple, chacun des guides WP1, $WS1_1$ et $WS1_2$ présente une épaisseur sensiblement constante sur toute sa longueur. Chacun des guides WP1, $WS1_1$ et $WS1_2$ est réalisé en un premier matériau transparent et est entouré d'une gaine en un deuxième matériau transparent d'indice de réfraction plus faible. A titre d'exemple, les guides WP1, $WS1_1$ et $WS1_2$ sont en un même premier matériau, et sont enrobés dans une même région de gainage continue G1 en un deuxième matériau de plus faible indice de réfraction. Les axes optiques des guides WP1, $WS1_1$ et $WS1_2$ sont par exemple sensiblement parallèles, mais non confondus. Dans cet exemple, les axes optiques des guides WP1, $WS1_1$ et $WS1_2$ sont sensiblement horizontaux.

Chaque guide secondaire $WS1_1$, $WS1_2$ comprend une première portion ou portion de couplage d'axe optique sensiblement parallèle à l'axe optique du guide WP1, disposée au voisinage du guide WP1 de façon à permettre un couplage par onde évanescente entre le guide principal WP1 et les guides secondaires $WS1_1$, $WS1_2$. Les guides secondaires $WS1_1$, $WS1_2$ sont de préférence agencés de façon que les coefficients de couplage entre le guide principal WP1 et chacun des guides secondaires $WS1_1$, $WS1_2$ soient sensiblement identiques. Pour cela, les guides secondaires $WS1_1$, $WS1_2$ peuvent être disposés à distance sensiblement égale du guide principal WP1. La distance d'axe optique à axe optique entre le guide principal WP1 et chacun des guides secondaires $WS1_1$, $WS1_2$ est par exemple sensiblement constante sur toute la longueur de la portion de couplage entre le guide principal WP1 et les guides secondaires $WS1_1$, $WS1_2$. La longueur de la portion de couplage entre le guide principal WP1 et les guides secondaires $WS1_1$, $WS1_2$, et la distance entre le guide principal WP1 et les guides secondaires $WS1_1$, $WS1_2$ le long de cette portion de couplage, sont choisies de façon à minimiser les pertes de couplage, par exemple selon les enseignements décrits dans les articles susmentionnés de B. Ben Bakir et al. et de X. Sun et al.

Dans l'exemple représenté, le long de la portion de couplage entre le guide principal WP1 et les guides secondaires $WS1_1$, $WS1_2$, le guide WP1 s'affine progressivement jusqu'à s'interrompre, tandis que les guides $WS1_1$ et $WS1_2$ s'élargissent progressivement. Cet agencement en pointes inversées des guides WP1 et $WS1_1$, $WS1_2$ permet d'améliorer le couplage entre le guide WP1 et les guides $WS1_1$ et $WS1_2$. Cet agencement permet en outre de rendre le couplage sensiblement indépendant de la longueur de la portion de couplage, pour autant que la longueur de la portion de couplage soit supérieure à une valeur minimale pouvant être déterminée à partir des enseignements des articles susmentionnés. On notera que la largeur finale des pointes formées par les terminaisons des guides WP1, $WS1_1$ et $WS1_2$ du côté de la zone de couplage entre le guide WP1 et les guides $WS1_1$ et $WS1_2$ n'a pas besoin d'être contrôlée précisément, dans la mesure où les pointes n'ont pas ici pour fonction de contrôler précisément la taille des modes pour réaliser à couplage bout à bout comme dans l'exemple des figures 1A et 1B, mais seulement de faciliter le transfert d'énergie lumineuse par onde évanescente entre le guide principal WP1 et les guides secondaires $WS1_1$ et $WS1_2$. Par ailleurs, les modes de réalisation décrits ne se limitent pas au cas particulier où le guide principal WP1 et les guides secondaires $WS1_1$, $WS1_2$ ont des formes en pointes inversées au niveau de la zone de couplage entre le guide WP1 et les guides $WS1_1$, $WS1_2$. A titre de variante, seul le guide principal WP1 peut présenter une terminaison en pointe, les guides secondaires $WS1_1$, $WS1_2$ ayant une section transversale régulière dans la zone de couplage entre le guide WP1 et les guides $WS1_1$, $WS1_2$. Alternativement, le guide principal WP1 peut présenter une section régulière, tandis que les guides secondaires $WS1_1$, $WS1_2$ peuvent s'élargir progressivement dans la zone de couplage entre le guide WP1 et les guides $WS1_1$, $WS1_2$. A titre de variante, le guide principal et les guides secondaires $WS1_1$, $WS1_2$ peuvent tous présenter une section régulière dans la zone de couplage entre le guide WP1 et les guides $WS1_1$, $WS1_2$.

Comme cela apparaît sur les figures 2A, 2B et 2C, à la fin de la portion de couplage entre le guide principal WP1 et les guides secondaires $WS1_1$, $WS1_2$, le guide principal WP1 s'interrompt, tandis que chacun des guides secondaires $WS1_1$, $WS1_2$ se prolonge par une deuxième portion débouchant au niveau d'une face latérale du circuit C1. En d'autres termes, chacun des guides secondaires $WS1_1$, $WS1_2$ présente une face d'entrée/sortie ou face de couplage à un dispositif extérieur formant une portion d'une face latérale du circuit C1. Comme dans l'exemple décrit ci-dessus en relation avec les figures 1A et 1B, chaque guide secondaire $WS1_1$,

$WS1_2$ présente, du côté de sa face de couplage à un dispositif extérieur, une portion de terminaison en forme de pointe, c'est-à-dire dans laquelle sa largeur décroît progressivement jusqu'à atteindre une valeur minimale au niveau de la face de couplage, de façon à augmenter la taille des modes au niveau des faces de couplage tout en conservant une largeur de guide suffisamment importante pour pouvoir être reproduite avec une bonne précision. A titre d'exemple, la largeur des guides secondaires $WS1_1$, $WS1_2$ au niveau de la face de couplage du circuit C1 est comprise entre 0,1 et 0,5 $\mu$m. De préférence, la longueur de la pointe est supérieure à 100 fois la longueur d'onde de la lumière destinée à être transmise par la structure de couplage.

Ainsi, la structure décrite permet de coupler optiquement le guide principal WP1 à un dispositif extérieur, par couplage évanescent entre le guide WP1 et les guides $WS1_1$, $WS1_2$, puis par couplage bout à bout entre les guides $WS1_1$, $WS1_2$ et le dispositif extérieur.

Dans l'exemple représenté, le circuit C2 comprend une structure de couplage sensiblement symétrique, comportant un guide d'onde principal WP2, et deux guides d'ondes secondaires $WS2_1$ et $WS2_2$ entourés d'un matériau de gainage G2 de plus faible indice de réfraction. Les guides d'ondes WP2, $WS2_1$ et $WS2_2$ sont agencés de façon d'une part à réaliser un couplage par ondes évanescentes entre le guide principal WP2 et les guides secondaires $WS2_1$ et $WS2_2$, et d'autre part à permettre un couplage bout à bout entre les guides secondaires $WS2_1$ et $WS2_2$ et un dispositif extérieur, de façon similaire à ce qui a été décrit pour le circuit C1. Le couplage entre les circuits C1 et C2 est un couplage bout à bout, c'est-à-dire que les circuits C1 et C2 sont juxtaposés de façon à accoler la face de couplage du guide $WS1_1$ contre la face de couplage du guide $WS2_1$ et la face de couplage du guide $WS1_2$ contre la face de couplage du guide $WS2_2$, de façon que les axes optiques des guides $WS1_1$ et $WS2_1$ d'une part, et $WS1_2$ et $WS2_2$ d'autre part, soient confondus au niveau de la zone de couplage. Les matériaux des éléments WP2, $WS2_1$, $WS2_2$ et/ou G2 du circuit C2 peuvent être identiques aux matériaux des éléments correspondants WP1, $WS1_1$, $WS1_2$ et/ou G1 du circuit C1. A titre de variante, un ou plusieurs des éléments WP2, $WS2_1$, $WS2_2$ et G2 du circuit C2 sont réalisés en des matériaux différents des éléments correspondants du circuit C1. Par exemple, le matériau de gaine G2 du circuit C2 peut être différent du matériau de gaine G1 du circuit C1, et/ou le matériau de coeur des guides secondaires $WS2_1$ et/ou $WS2_2$ du circuit C2 peut être différent du matériau de coeur des guides secondaires $WS1_1$ et/ou $WS1_2$ du circuit C1.

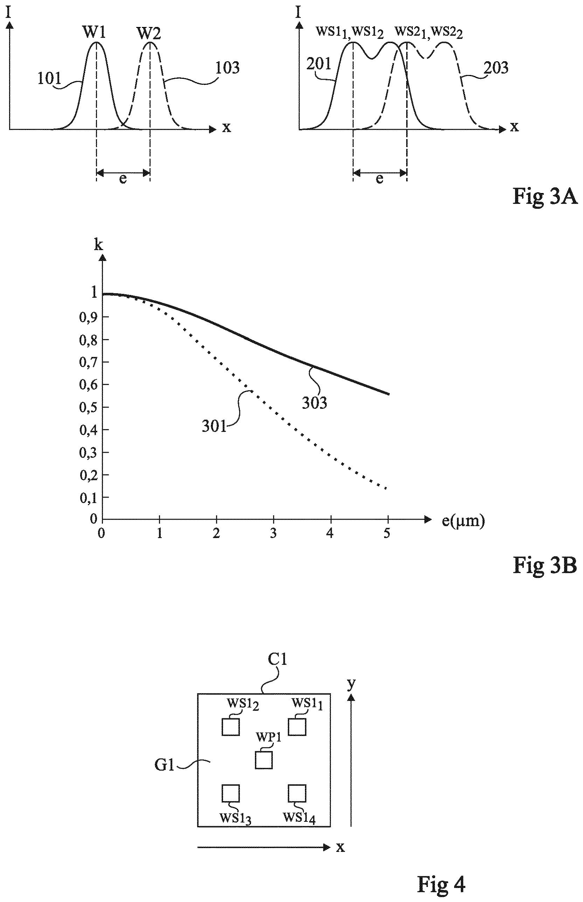

Les figures 3A et 3B illustrent un avantage de la structure de couplage des figures 2A, 2B, 2C, 2D par rapport à la structure de couplage des figures 1A, 1B.

La figure 3A comprend un premier diagramme, en partie gauche de la figure, représentant, pour la structure de couplage des figures 1A, 1B, la distribution de l'énergie lumineuse I portée par les guides W1 et W2 selon une direction x transverse aux guides, par exemple une direction verticale dans l'orientation de la figure 1A. Ce premier diagramme comprend une courbe 101 en trait continu correspondant à la distribution de l'énergie lumineuse portée par le guide W1 au niveau de la face de couplage du guide W1, et une courbe 103 en trait interrompu correspondant à la distribution de l'énergie lumineuse portée par le guide W2 au niveau de la face de couplage du guide W2. On se place ici dans le cas où il existe une erreur d'alignement e selon la direction x entre les guides W1 et W2, c'est-à-dire que les axes optiques ou axes centraux des guides W1 et W2 sont décalés d'une distance e selon la direction x au niveau de la zone de couplage. Comme cela apparaît sur la figure, dans cet exemple, les distributions 101 et 103 sont sensiblement gaussiennes, et ont des formes générales sensiblement identiques. Toutefois, du fait de l'erreur d'alignement e entre les guides W1 et W2, les distributions 101 et 103 ne sont pas alignées. Dans l'exemple représenté, l'aire de recouvrement entre les courbes 101 et 103 est très restreinte, d'où il résulte un coefficient de couplage particulièrement faible entre les guides W1 et W2.

La figure 3A comprend en outre un deuxième diagramme, en partie droite de la figure, représentant, pour la structure de couplage des figures 2A, 2B, 2C, 2D, la distribution de l'énergie lumineuse I portée par les guides $WS1_1$ et $WS1_2$ d'une part, et $WS2_1$ et $WS2_2$ d'autre part, selon une direction x transverse aux guides, c'est-à-dire une direction verticale dans l'orientation de la figure 2A. Ce deuxième diagramme comprend une courbe 201 en trait continu correspondant à la distribution de l'énergie lumineuse portée par les guides $WS1_1$ et $WS1_2$ au niveau de la face de couplage du circuit C1, et une courbe 203 en trait interrompu correspondant à la distribution de l'énergie lumineuse portée par les guides $WS2_1$ et $WS2_2$ au niveau de la face de couplage du circuit C2. On se place ici dans le cas où il existe, entre les circuits C1 et C2, une erreur d'alignement e selon la direction x de même valeur que dans le premier diagramme, c'est-à-dire que les axes optiques des guides $WS1_1$ et $WS2_1$ d'une part, et $WS1_2$ et $WS2_2$ d'autre part sont décalés de la distance e selon la direction x au niveau de la zone de couplage. Comme cela apparaît sur la figure, dans cet exemple, chacune des distributions 201 et 203 correspond sensiblement à une somme de deux gaussiennes décalées selon l'axe x d'une distance égale à la distance d'axe optique à axe optique entre les guides $WS1_1$ et $WS1_2$ d'une part (pour la distribution 201) et $WS2_1$ et $WS2_2$ d'autre part (pour la distribution 203). Il en résulte que les distributions 201, respectivement 203 de la structure de couplage des figures 2A, 2B, 2C, 2D, sont nettement plus étendues que les distributions 101, respectivement 103 de la structure de couplage des figures 1A, 1B. En particulier, pour une même erreur d'alignement e, l'aire de recouvrement entre les courbes 201 et 203 est nettement supérieure à l'aire de recouvrement entre les courbes 101 et 103. Ainsi, pour une même erreur d'alignement e, le coefficient de couplage entre les circuits C1 et C2 est plus élevé avec la structure de couplage des figures 2A, 2B, 2C, 2D qu'avec la structure de couplage des figures 1A, 1B. La structure de couplage des figures 2A, 2B, 2C, 2D permet donc d'augmenter la tolérance aux erreurs d'alignement dans la direction x par rapport à la structure de couplage des figures 1A, 1B.

La figure 3B est un diagramme représentant l'évolution du coefficient de couplage k (valeur sans unité comprise entre 0 et 1) en fonction de l'erreur d'alignement e (en μm), pour une structure de couplage du type décrit en relation avec les figures 1A, 1B (courbe 301 de la figure 3B, en pointillés), et pour une structure de couplage du type décrit en relation avec les figures 2A à 2D (courbe 303 de la figure 3B, en trait plein). Comme cela apparaît sur la figure 3B, lorsque l'erreur d'alignement e augmente, le coefficient de couplage k décroît plus fortement pour la structure des figures 1A et 1B (courbe 301) que pour la structure des figures 2A à 2D (courbe 303). La structure de couplage des figures 2A à 2D présente donc une meilleure tolérance aux erreurs d'alignement que la structure de couplage des figures 1A, 1B.

La distance entre les guides secondaires $WS1_1$ et $WS1_2$ (respectivement $WS2_1$ et $WS2_2$) au niveau de la face de couplage du circuit C1 (respectivement C2) est de préférence choisie suffisamment faible pour que les faisceaux portés par les guides secondaires se recouvrent partiellement au niveau de la face de couplage de la structure. A titre d'exemple, pour une largeur donnée des guides secondaires au niveau de la face de couplage (par exemple la largeur minimale reproductible dans la technologie considérée), on peut assimiler le faisceau porté par chaque guide secondaire au niveau de sa face de couplage à un faisceau gaussien de rayon R, c'est-à-dire tel que l'intensité lumineuse I au niveau de la face de couplage soit définie par la relation

$$I = e^{-\left(\frac{x^2+y^2}{R^2}\right)},$$

x et y étant les coordonnées dans le plan de la face de couplage du guide, dans un repère orthogonal centré sur l'axe optique du guide. La distance centre à centre entre les guides secondaires $WS1_1$ et $WS1_2$ au niveau de la face de couplage de la structure est par exemple comprise entre R et 3R, et de préférence de l'ordre de 2R.

La figure 4 illustre une réalisation de la structure de couplage selon l'invention, qui est une variante de la structure de couplage des figures 2A, 2B, 2C, 2D. Sur la figure 4, seule une coupe transversale du circuit C1 dans le même plan de coupe que celui de la figure 2D a été représentée, étant entendu que, en pratique, la structure de couplage du circuit C1 représentée en figure 4 peut être couplée à une structure de couplage symétrique d'un circuit C2 de façon similaire à ce qui a été décrit précédemment. La structure de la figure 4 diffère de la structure des figures 2A, 2B, 2C, 2D principalement en ce qu'elle comprend non pas deux, mais quatre guides secondaires $WS1_1$, $WS1_2$, $WS1_3$, $WS1_4$, par exemple sensiblement identiques, couplés par couplage évanescent avec le guide principal WP1 et débouchant sur une face latérale du circuit C1. Dans la structure de la figure 4, au niveau de la face de couplage du circuit C1, les axes optiques des guides secondaires $WS1_1$ et $WS1_3$ d'une part, et $WS1_2$ et $WS1_4$ d'autre part définissent deux plans sensiblement orthogonaux. Il en résulte que la structure de couplage de la figure 4 permet d'améliorer la tolérance aux erreurs d'alignement non seulement dans la direction x, mais aussi dans une direction y orthogonale à la direction x et orthogonale à la direction de propagation de la lumière au niveau de la zone de couplage. De même que dans l'exemple des figures 2A, 2B, 2C, 2D, la distance maximale entre deux guides secondaires de la structure de la figure 4 est de préférence choisie suffisamment faible pour que les faisceaux portés par les guides se recouvrent partiellement au niveau de la face de couplage de la structure. Par exemple, si on appelle R le rayon des faisceaux (assimilés à des faisceaux gaussiens) portés par les guides secondaires au niveau de la face de couplage de la structure, la distance centre à centre maximale entre deux guides secondaires au niveau de la face de couplage peut être de l'ordre de 2R.

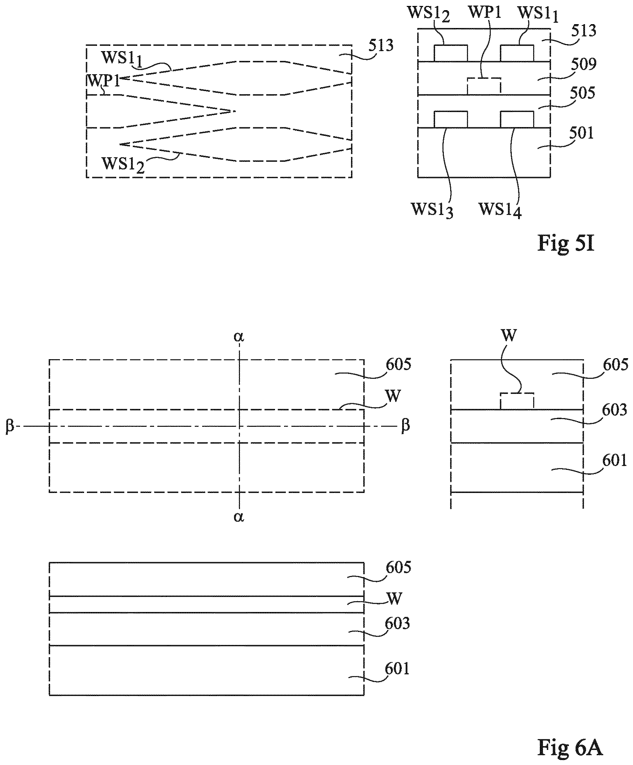

La figure 4 représente une configuration préférée dans laquelle les guides WP1, $WS1_1$, $WS1_2$, $WS1_3$ et $WS1_4$ sont à section rectangulaire, et dans laquelle, au niveau de la zone de couplage entre le guide WP1 et les guides $WS1_1$, $WS1_2$, $WS1_3$ et $WS1_4$, les guides $WS1_1$, $WS1_2$, $WS1_3$ et $WS1_4$ sont placés à égale distance du guide WP1, et sont situés, en section transversale, respectivement aux quatre coins du guide WP1. En d'autres termes, dans l'exemple de la figure 4, en section transversale, les axes optiques des guides secondaires $WS1_1$ et $WS1_3$ sont situés de part et d'autre du guide WP1 sur une première diagonale du guide WP1, et les axes optiques des guides secondaires $WS1_2$ et $WS1_4$ sont situés de part et d'autre du guide WP1 sur la deuxième diagonale du guide WP1. Un avantage de cette configuration est lié au fait que, dans un guide d'onde à section rectangulaire, la lumière est généralement polarisée. La disposition des guides secondaires sur les axes diagonaux de symétrie du guide principal permet que le couplage entre le guide principal et les guides secondaires s'effectue sensiblement de la même manière dans les quatre guides secondaires, c'est-à-dire que les coefficients de couplage entre le guide principal et les quatre guides secondaires soient sensiblement les mêmes. Cette disposition est notamment particulièrement avantageuse lorsque le guide d'onde principal WP1 est à section transversale rectangulaire non carrée, tel qu'illustré par exemple sur les figures 5I, 6C et 7D décrites ci-après.

On notera de plus que comme dans l'exemple des figures 2A à 2D, les matériaux des éléments de la structure de couplage du circuit C2 peuvent être différents des matériaux des éléments correspondants de la structure de couplage du circuit C1. Par exemple, le matériau de gaine G2 du circuit C2 peut être différent du matériau de gaine G1 du circuit C1, et/ou le matériau de coeur des guides secondaires $WS2_1$ et/ou $WS2_2$ et/ou $WS2_3$ et/ou $WS2_4$ du circuit C2 peut être différent du matériau de coeur des guides secondaires $WS1_1$ et/ou $WS1_2$ et/ou $WS1_3$ et/ou $WS1_4$ du circuit C1. La disposition des guides secondaires sur les axes diagonaux de symétrie du guide principal est tout particulièrement avantageuse lorsque, pour au moins l'une des paires de guides secondaires située sur une même diagonale, le matériau de coeur et/ou le matériau de gaine des guides secondaires de la structure de couplage du circuit C1 est différent du matériau de coeur et/ou du matériau de gaine des guides secondaires correspondants de la structure de couplage du circuit C2.

Des exemples de procédé de fabrication d'une structure de couplage du type décrit ci-dessus vont maintenant être décrits.

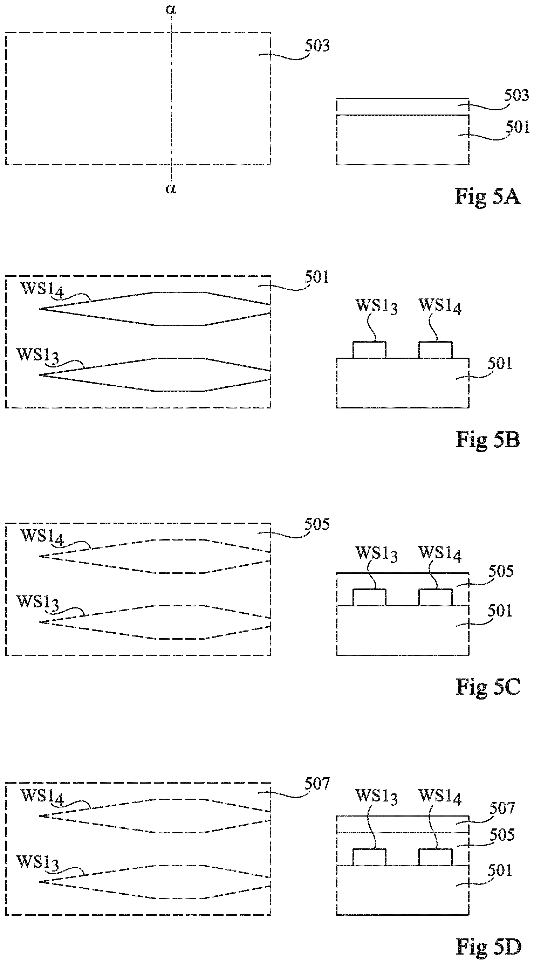

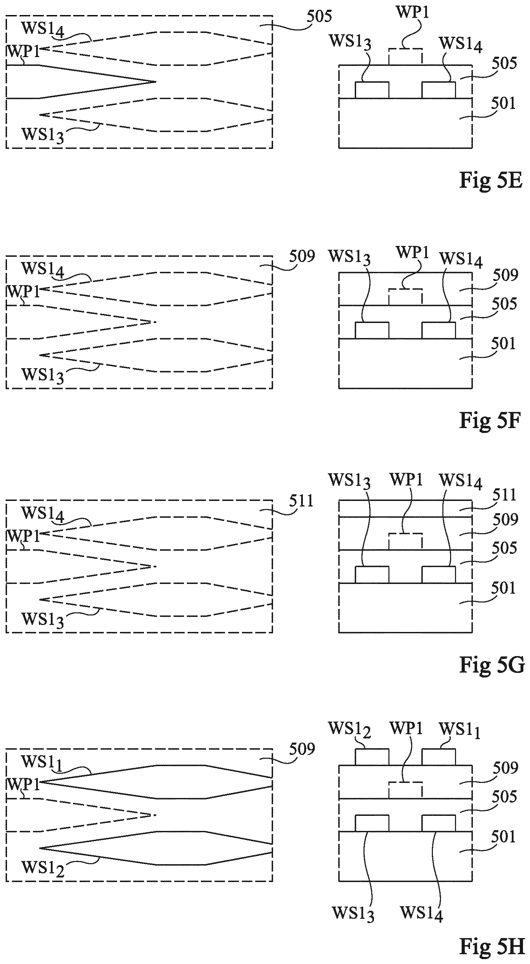

Les figures 5A, 5B, 5C, 5D, 5E, 5F, 5G, 5H, 5I illustrent des étapes d'un exemple de procédé de fabrication d'une structure de couplage du type décrit en relation avec la figure 4.

On considère dans cet exemple que la structure de couplage est intégrée dans un circuit photonique utilisant le silicium-germanium (SiGe) comme matériau de haut indice et le silicium (Si) comme matériau de bas indice. Ce type de circuit peut par exemple être utilisé dans la gamme spectrale du moyen infrarouge, par exemple pour traiter des signaux optiques de longueurs d'ondes comprises dans la plage allant de 3 à 12 $\mu$m. A titre de variante, pour cette même gamme de longueurs d'ondes, un procédé de fabrication similaire pourra être mis en oeuvre pour réaliser une structure de couplage utilisant le germanium comme matériau de haut indice (coeur) et le silicium-germanium comme matériau de bas indice (gaine).

Les figures 5A, 5B, 5C, 5D, 5E, 5F, 5G, 5H, 5I comprennent chacune, en partie gauche de la figure, une vue de dessus de la structure, et, en partie droite de la figure, une vue en coupe selon le plan $\alpha$-$\alpha$ de la figure 5A.

La figure 5A illustre une étape initiale au cours de laquelle on part d'un substrat 501 en silicium cristallin, sur la face supérieure duquel on dépose, par exemple par épitaxie, une couche de silicium-germanium 503.

La figure 5B illustre une étape postérieure à l'étape de la figure 5A, au cours de laquelle les guides secondaires inférieurs $WS1_4$ et $WS1_3$ de la structure de la figure 4 sont délimités dans la couche de silicium-germanium 503, par exemple par lithographie et gravure.

La figure 5C illustre une étape de dépôt, par exemple par épitaxie, d'une couche de silicium 505 d'épaisseur supérieure à l'épaisseur de la couche de silicium-germanium 503, sur la face supérieure de la structure obtenue à l'issue de l'étape de la figure 5B. La couche de silicium 505 peut ensuite être planarisée, par exemple par planarisation mécano-chimique (CMP). A l'issue de cette étape, la couche de silicium 505 comble l'espace entourant latéralement les guides secondaires

WS1$_4$ et WS1$_3$ et recouvre entièrement les faces supérieures des guides secondaires WS1$_4$ et WS1$_3$.

La figure 5D illustre une étape postérieure à l'étape de la figure 5C, au cours de laquelle une couche de silicium-germanium 507 est déposée, par exemple par épitaxie, sur la face supérieure de la couche 505.

La figure 5E illustre une étape postérieure à l'étape de la figure 5D, au cours de laquelle le guide principal WP1 de la structure de la figure 4 est délimité dans la couche de silicium-germanium 507, par exemple par lithographie et gravure.

La figure 5F illustre une étape de dépôt, par exemple par épitaxie, d'une couche de silicium 509 d'épaisseur supérieure à l'épaisseur de la couche de silicium-germanium 507, sur la face supérieure de la structure obtenue à l'issue de l'étape de la figure 5E. La couche de silicium 509 peut ensuite être planarisée, par exemple par planarisation mécano-chimique (CMP). A l'issue de cette étape, la couche de silicium 509 comble l'espace entourant latéralement le guide principal WP1, et recouvre entièrement la face supérieure du guide principal WP1.

La figure 5G illustre une étape postérieure à l'étape de la figure 5F, au cours de laquelle une couche de silicium-germanium 511 est déposée, par exemple par épitaxie, sur la face supérieure de la couche 509.

La figure 5H illustre une étape postérieure à l'étape de la figure 5G, au cours de laquelle les guides secondaires supérieurs WS1$_1$ et WS1$_2$ de la structure de la figure 4 sont délimités dans la couche de silicium-germanium 511, par exemple par lithographie et gravure.

La figure 5I illustre une étape de dépôt, par exemple par épitaxie, d'une couche de silicium 513 d'épaisseur supérieure à l'épaisseur de la couche de silicium-germanium 511, sur la face supérieure de la structure obtenue à l'issue de l'étape de la figure 5H. La couche de silicium 513 peut ensuite être planarisée, par exemple par planarisation mécano-chimique (CMP). A l'issue de cette étape, la couche de silicium 513 comble l'espace entourant latéralement les guides secondaires WS1$_1$ et WS1$_2$, et recouvre entièrement la face supérieure des guides secondaires WS1$_1$ et WS1$_2$.

A l'issue de l'étape de la figure 5I, on obtient une structure de couplage similaire à celle de la figure 4, les couches de silicium 501, 505, 509 et 513 formant la gaine de matériau de bas indice G1 de la structure.

Pour la gamme du proche infrarouge, par exemple pour des signaux optiques de longueurs d'ondes comprises entre 0,8 et 2 $\mu$m, un procédé similaire peut être mis en oeuvre en utilisant de l'oxyde de silicium comme matériau de bas indice, et du silicium amorphe comme matériau d'indice supérieur. A titre de variante, pour cette même gamme de longueurs d'ondes ou pour de la lumière visible (par exemple dans la gamme de longueurs d'ondes allant de 0,3 à 0,8 $\mu$m), un procédé de fabrication similaire peut être mis en oeuvre en utilisant du nitrure de silicium (SiN) comme matériau de haut indice et de l'oxyde de silicium comme matériau de bas indice.

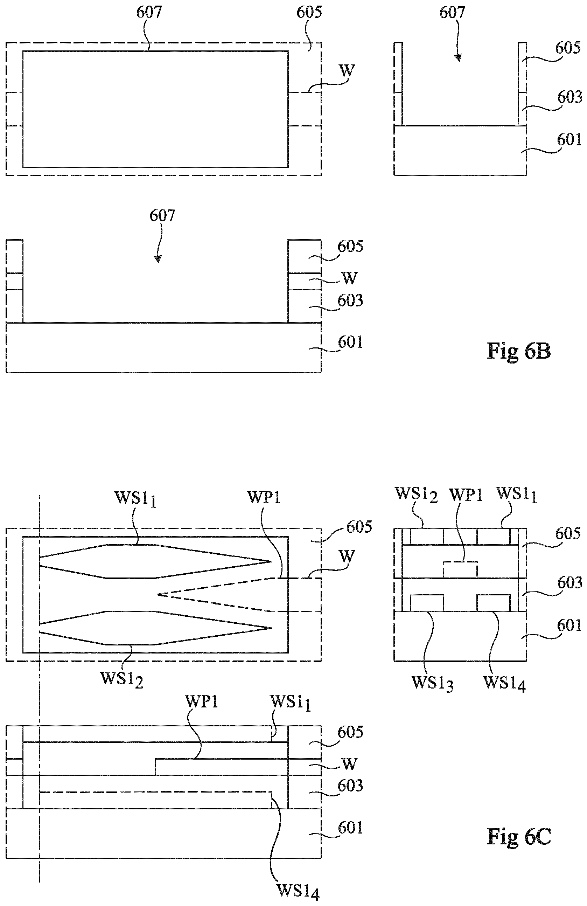

Les figures 6A, 6B, 6C illustrent des étapes d'un autre exemple de procédé de fabrication d'une structure de couplage du type décrit en relation avec la figure 4.

Les figures 6A, 6B, 6C comprennent chacune, en partie supérieure gauche de la figure, une vue de dessus de la structure, en partie supérieure droite de la figure, une vue en coupe transversale selon le plan $\alpha$-$\alpha$ de la figure 6A, et en partie inférieure gauche de la figure, une vue en coupe longitudinale selon le plan $\beta$-$\beta$ de la figure 6A.

Dans cet exemple, on considère un circuit photonique réalisé en technologie SOI (silicium sur isolant), auquel on souhaite adjoindre une structure de couplage du type décrit en relation avec la figure 4.

La figure 6A illustre une structure de départ comprenant un substrat de support 601 en silicium, surmonté d'une couche d'oxyde de silicium 603. Un guide d'onde W interne au circuit photonique, réalisé en silicium cristallin, est disposé sur la face supérieure de la couche d'oxyde de silicium 603. Le guide d'onde 603 est entouré latéralement et du côté de sa face supérieure par une couche d'oxyde de silicium planarisée 605.

La figure 6B illustre une étape de formation, depuis la face supérieure de la structure de la figure 6A, d'une cavité ou évidement 607 au niveau d'une zone périphérique du circuit dans laquelle on souhaite réaliser la structure de couplage. La cavité 607 s'étend, en profondeur, jusqu'à la face supérieure du substrat de silicium 601. La cavité 607 est localisée de façon que le guide d'onde interne W débouche dans la cavité 607.

La figure 6C illustre une étape de formation, dans la cavité 607, d'une structure de couplage du type décrit en relation avec la figure 4, par dépôts successifs de couches d'oxyde de silicium (comme matériau de plus faible indice) et de couches de silicium amorphe (comme matériau de plus haut indice), par exemple selon un procédé similaire à ce qui a été décrit en relation avec les figures 5A à 5I. A titre de variante, le matériau de haut indice peut être du nitrure de silicium et le matériau de bas indice peut être de l'oxyde de silicium. Dans cet exemple, on veille, lors de cette étape, à aligner le guide principal WP1 de la structure de couplage avec le guide interne W du circuit photonique, de façon que le guide WP1 forme un prolongement du guide interne W. En d'autres termes, dans l'exemple représenté, une face du guide interne W débouchant dans la cavité 607 est accolée à la face du guide principal WP1 opposée à la région de couplage entre le guide principal WP1 et les guides secondaires WS1$_1$, WS1$_2$, WS1$_3$ et WS1$_4$. Ainsi, la structure réalisée permet de coupler le guide interne W du circuit photonique à un dispositif extérieur.

Une fois les guides WP1, WS1$_1$, WS1$_2$, WS1$_3$ et WS1$_4$ de la structure de couplage réalisés, la structure obtenue peut être découpée, par exemple par clivage, selon un plan de coupe vertical passant par les faces de couplage des guides secondaires WS1$_1$, WS1$_2$, WS1$_3$ et WS1$_4$, de façon à faire déboucher les faces de cou-

plage des guides secondaires WS1$_1$, WS1$_2$, WS1$_3$ et WS1$_4$ sur une face latérale du circuit photonique.

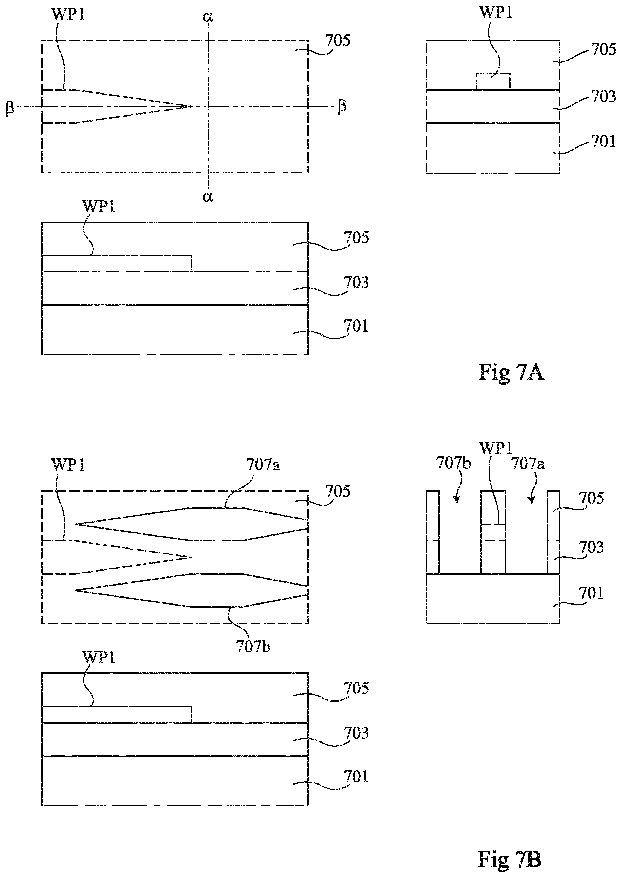

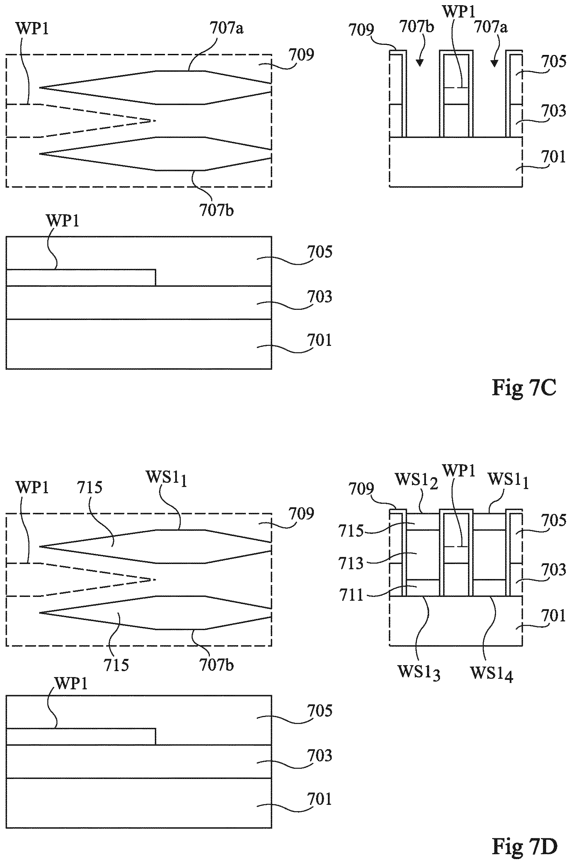

Les figures 7A, 7B, 7C, 7D illustrent des étapes d'un autre exemple de procédé de fabrication d'une structure de couplage du type décrit en relation avec la figure 4.

Les figures 7A, 7B, 7C, 7D comprennent chacune, en partie supérieure gauche de la figure, une vue de dessus de la structure, en partie supérieure droite de la figure, une vue en coupe transversale selon le plan $\alpha$-$\alpha$ de la figure 7A, et en partie inférieure gauche de la figure, une vue en coupe longitudinale selon le plan $\beta$-$\beta$ de la figure 7A.

Dans cet exemple, le circuit photonique dans lequel est formée la structure de couplage est un circuit actif intégrant une source laser.

La figure 7A illustre une structure de départ comprenant un substrat de support 701 en phosphure d'indium (InP), surmonté d'une couche tampon 703, également en phosphure d'indium. La couche tampon 703 est surmontée d'un empilement actif de diode laser, par exemple un empilement de puits quantiques à base d'arséniure d'indium-gallium (InGaAs), dans lequel sont formés la source laser (non visible sur la figure) du circuit, ainsi que, couplé à la source laser, un guide d'onde correspondant au guide d'onde principal WP1 de la structure de couplage. L'empilement actif est surmonté d'une couche supérieure 705 de phosphure d'indium, qui entoure le guide d'onde WP1 latéralement et du côté de sa face supérieure.

La figure 7B illustre une étape de formation, depuis la face supérieure de la structure de la figure 7A, de deux tranchées ou cavités 707a et 707b s'étendant verticalement dans la structure jusqu'à la face supérieure du substrat 701. En vue de dessus, la tranchée 707a a sensiblement la forme des guides secondaires WS1$_1$ et WS1$_4$ de la structure de couplage que l'on cherche à réaliser, et la tranchée 707b a sensiblement la forme des guides secondaires WS1$_2$ et WS1$_3$ de la structure de couplage que l'on cherche à réaliser.

La figure 7C illustre une étape de dépôt d'une couche de passivation 709, par exemple en oxyde de silicium, sur la surface supérieure de la structure obtenue à l'issue de l'étape de la figure 7B, suivie d'une étape de retrait localisé de la couche 709 au fond des tranchées 707a, 707b. A l'issue de cette étape, la couche 709 revêt sensiblement toute la surface supérieure du circuit, ainsi que les parois latérales des tranchées 707a, 707b, mais laisse accessible la surface supérieure du substrat 701 au fond des tranchées 707a, 707b.

La figure 7D illustre une étape postérieure à l'étape de la figure 7C, au cours de laquelle sont successivement déposées dans les tranchées 707a, 707b, par exemple par épitaxie, une première couche d'arséniure d'indium-gallium 711 formant les guides d'ondes secondaires inférieurs WS1$_4$ et WS1$_3$ de la structure de couplage respectivement dans les tranchées 707a et 707b, une couche de phosphure d'indium 713, et une deuxième couche d'arséniure d'indium-gallium 715 formant les guides d'ondes secondaires supérieurs WS1$_1$ et WS1$_2$ de la structure de couplage respectivement dans les tranchées 707a et 707b.

Des modes de réalisation particuliers ont été décrits. Diverses variantes et modifications apparaîtront à l'homme de l'art. En particulier, les modes de réalisation décrits ne se limitent pas aux exemples de dimensions et de matériaux décrits ci-dessus.

De plus, les modes de réalisation décrits ne se limitent pas aux exemples décrits ci-dessus dans lesquels la structure de couplage comprend deux ou quatre guides secondaires. Plus généralement, une augmentation de la tolérance aux erreurs d'alignement peut être obtenue dès lors que la structure de couplage comprend au moins deux guides secondaires.

En outre, les modes de réalisation décrits ne se limitent pas aux exemples susmentionnés dans lesquels la structure de couplage comprend des guides d'ondes à section rectangulaire. Plus généralement, les modes de réalisation s'appliquent quelle que soit la forme des guides d'ondes de la structure de couplage. A titre d'exemple, les guides d'ondes de la structure de couplage peuvent être à section circulaire ou elliptique.

Par ailleurs, bien que l'on ait décrit uniquement des exemples dans lesquels la structure de couplage proposée est utilisée pour coupler le circuit photonique auquel elle est intégrée à un autre circuit photonique, les modes de réalisation décrits ne se limitent pas à cette application particulière. En effet, les structures de couplage décrites peuvent être utilisées pour coupler un circuit photonique à un autre dispositif optique, par exemple une fibre optique.

**Revendications**

1. Circuit photonique (C1) comportant une structure de couplage à un dispositif extérieur, cette structure comportant un guide d'onde principal (WP1) à section transversale rectangulaire et quatre guides d'ondes secondaires (WS1$_1$, WS1$_2$, WS1$_3$, WS1$_4$), chaque guide secondaire (WS1$_1$, WS1$_2$, WS1$_3$, WS1$_4$) ayant une première portion sensiblement parallèle au guide principal (WP1) disposée au voisinage du guide principal (WP1) de façon à réaliser un couplage par onde évanescente entre le guide principal (WP1) et le guide secondaire, la première portion se prolongeant par une deuxième portion dont une extrémité opposée à la première portion définit une face de couplage du guide secondaire, débouchant au niveau d'une face extérieure du circuit, dans lequel les premières portions des quatre guides secondaires (WS1$_1$, WS1$_2$, WS1$_3$, WS1$_4$) sont, en section transversale, disposées autour du guide principal (WP1) sur les diagonales du guide principal.

2. Circuit selon la revendication 1, dans lequel chaque

guide secondaire (WS1$_1$, WS1$_2$, WS1$_3$, WS1$_4$) présente une terminaison en pointe du côté de sa face de couplage.

**3.** Circuit selon la revendication 1 ou 2, dans lequel les coefficients de couplage entre le guide principal (WP1) et chacun des guides secondaires (WS1$_1$, WS1$_2$, WS1$_3$, WS1$_4$) sont sensiblement identiques.

**4.** Circuit selon l'une quelconque des revendications 1 à 3, dans lequel les premières portions des guides secondaires (WS1$_1$, WS1$_2$, WS1$_3$, WS1$_4$) sont sensiblement à égale distance du guide principal (WP1).

**5.** Circuit selon l'une quelconque des revendications 1 à 4, dans lequel la distance centre à centre maximale entre deux guides secondaires (WS1$_1$, WS1$_2$, WS1$_3$, WS1$_4$) au niveau de leurs faces de couplage est sensiblement égale à deux fois le rayon du faisceau lumineux propagé par chaque guide secondaire au niveau de sa face de couplage.

**6.** Circuit selon l'une quelconque des revendications 1 à 5, dans lequel, le long de leurs premières portions, les guides secondaires (WS1$_1$, WS1$_2$, WS1$_3$, WS1$_4$) s'élargissent progressivement jusqu'à atteindre une largeur maximale au niveau de leurs deuxièmes portions.

**7.** Circuit selon l'une quelconque des revendications 1 à 6, dans lequel, le long des premières portions des guides secondaires, le guide principal (WP1) s'affine progressivement.

**8.** Circuit selon l'une quelconque des revendications 1 à 7, dans lequel le guide principal s'interrompt avant la face extérieure du circuit (C1).

**9.** Circuit selon l'une quelconque des revendications 1 à 8, dans lequel le guide d'onde principal (WP1) et les guides d'ondes secondaires (WS1$_1$, WS1$_2$, WS1$_3$, WS1$_4$) sont en silicium-germanium et sont entourés de silicium.

**10.** Circuit selon l'une quelconque des revendications 1 à 8, dans lequel le guide d'onde principal (WP1) et les guides d'ondes secondaires (WS1$_1$, WS1$_2$, WS1$_3$, WS1$_4$) sont en silicium amorphe et sont entourés d'oxyde de silicium.

**11.** Circuit selon la revendication 10, dans lequel le guide d'onde principal (WP1) forme un prolongement d'un guide d'onde (W) interne au circuit (C1), le guide d'onde interne (W) étant en silicium cristallin.

**12.** Circuit selon l'une quelconque des revendications 1 à 8, comprenant une source laser intégrée, le guide d'onde principal (WP1) étant couplé à la source laser.

**13.** Dispositif comprenant des premier (C1) et deuxième (C2) circuits photoniques selon l'une quelconque des revendications 1 à 12, dans lequel les faces de couplage des quatre guides secondaires (WS1$_1$, WS1$_2$, WS1$_3$, WS1$_4$) du premier circuit (C1) sont accolées respectivement aux faces de couplage des quatre guides secondaires (WS2$_1$, WS2$_2$, WS2$_3$, WS2$_4$) du deuxième circuit (C2).

**14.** Dispositif selon la revendication 13, dans lequel au moins l'un des guides secondaires (WS1$_1$, WS1$_2$, WS1$_3$, WS1$_4$) du premier circuit (C1) est en un matériau différent du guide secondaire (WS2$_1$, WS2$_2$, WS2$_3$, WS2$_4$) correspondant du deuxième circuit (C2).

**15.** Dispositif selon la revendication 13 ou 14, dans lequel :

le premier circuit intègre une source laser à base de matériaux semiconducteurs III-V, le guide principal (WP1) du premier circuit étant couplé à ladite source laser ; et
le guide principal (WP2) et les guides secondaires (WS2$_1$, WS2$_2$, WS2$_3$, WS2$_4$) du deuxième circuit sont en silicium-germanium entouré de silicium, ou en silicium entouré d'oxyde de silicium.

**Patentansprüche**

**1.** Photonische Schaltung (C1) mit einer Kopplungsstruktur zu einer externen Vorrichtung, wobei die Struktur einen Hauptwellenleiter (WP1) mit rechteckigem Querschnitt und vier sekundären Wellenleitern (WS1$_1$, WS1$_2$, WS1$_3$, WS1$_4$) aufweist, wobei jeder sekundäre Wellenleiter (WS1$_1$, WS1$_2$, WS1$_3$, WS1$_4$) einen ersten Teil besitzt im Wesentlichen parallel zu dem Hauptleiter (WP1), der in der Nähe des Hauptleiters (WP1) angeordnet ist, um eine evaneszente Wellenkopplung zwischen dem Hauptleiter (WP1) und dem sekundären Leiter durchzuführen, wobei sich der erste Teil in einen zweiten Teil erstreckt mit einem Ende entgegengesetzt zu dem ersten Teil, das eine Kopplungsoberfläche des sekundären Leiters definiert, das an einer Außenoberfläche der Schaltung heraustritt, wobei die ersten Teile der vier sekundären Leiter (WS1$_1$, WS1$_2$, WS1$_3$, WS1$_4$) im Querschnitt um den Hauptleiter (WP1) an den Diagonalen des Hauptleiters angeordnet sind.

**2.** Schaltung nach Anspruch 1, wobei jeder sekundäre Leiter (WS1$_1$, WS1$_2$, WS1$_3$, WS1$_4$) ein sich verjüngendes Ende an der Seite seiner Kopplungsoberfläche aufweist.

**3.** Schaltung nach Anspruch 1 oder 2, wobei die Kopplungskoeffizienten zwischen dem Hauptleiter (WP1) und jeder der sekundären Leiter (WS1$_1$, WS1$_2$, WS1$_3$, WS1$_4$) im Wesentlichen identisch sind.

**4.** Schaltung nach einem der Ansprüche 1 bis 3, wobei die ersten Teile der sekundären Leiter (WS1$_1$, WS1$_2$, WS1$_3$, WS1$_4$) im Wesentlichen gleich weit von dem Hauptleiter (WP1) entfernt sind.

**5.** Schaltung nach einem der Ansprüche 1 bis 4, wobei der maximale Mitte-zu-Mitte-Abstand zwischen zwei sekundären Leitern (WS1$_1$, WS1$_2$, WS1$_3$, WS1$_4$) an dem Niveau ihrer Kopplungsoberflächen im Wesentlichen gleich dem zweifachen Radius des Lichtstrahls ist, der sich durch jeden sekundären Leiter an dem Niveau seiner Kopplungsoberfläche ausbreitet.

**6.** Schaltung nach einem der Ansprüche 1 bis 5, wobei sich die sekundären Leiter (WS1$_1$, WS1$_2$, WS1$_3$, WS1$_4$) entlang ihrer ersten Teile allmählich erweitern, bis sie an dem Niveau ihrer zweiten Teile eine maximale Breite erreichen.

**7.** Schaltung nach einem der Ansprüche 1 bis 6, wobei die Hauptleiter (WP1) entlang der ersten Teile der sekundären Leiter allmählich dünner wird.

**8.** Schaltung nach einem der Ansprüche 1 bis 7, wobei der Hauptleiter vor der Außenoberfläche der Schaltung (C1) stoppt.

**9.** Schaltung nach einem der Ansprüche 1 bis 8, wobei der Hauptwellenleiter (WP1) und die sekundären Wellenleiter (WS1$_1$, WS1$_2$, WS1$_3$, WS1$_4$) aus Silizium-Germanium hergestellt sind und mit Silizium umgeben sind.

**10.** Schaltung nach einem der Ansprüche 1 bis 8, wobei der Hauptwellenleiter (WP1) und die sekundären Wellenleiter (WS1$_1$, WS1$_2$, WS1$_3$, WS1$_4$) aus amorphem Silizium hergestellt sind und mit Siliziumoxid umgeben sind.

**11.** Schaltung nach Anspruch 10, bei der der Hauptwellenleiter (WP1) eine Verlängerung eines Wellenleiters (W) innerhalb der Schaltung (C1) bildet, wobei der innere Wellenleiter (W) aus kristallinem Silizium hergestellt ist.

**12.** Schaltung nach einem der Ansprüche 1 bis 8, die eine integrierte Laserquelle aufweist, wobei der Hauptwellenleiter (WP1) mit der Laserquelle gekoppelt ist.

**13.** Eine Vorrichtung, die erste (C1) und zweite (C2) photonische Schaltungen nach einem der Ansprüche 1 bis 12 aufweist, wobei die Kopplungsflächen der vier sekundären Leiter (WS1$_1$, WS1$_2$, WS1$_3$, WS1$_4$) der ersten Schaltung (C1) jeweils gegen die Kopplungsoberflächen der vier sekundären Leiter (WS2$_1$, WS2$_2$, WS2$_3$, WS2$_4$) der zweiten Schaltung (C2) angeordnet sind.

**14.** Vorrichtung nach Anspruch 13, wobei wenigstens einer der sekundären Leiter (WS1$_1$, WS1$_2$, WS1$_3$, WS1$_4$) der ersten Schaltung (C1) aus einem unterschiedlichen Material hergestellt ist als der entsprechende sekundäre Leiter (WS2$_1$, WS2$_2$, WS2$_3$, WS2$_4$) der zweiten Schaltung (C2).

**15.** Vorrichtung nach Anspruch 13 oder 14, wobei:

die erste Schaltung eine Laserquelle hergestellt aus III-V-Halbleitermaterialien integriert, wobei der Hauptleiter (WP1) der ersten Schaltung mit der Laserquelle gekoppelt ist; und
der Hauptleiter (WP2) und die sekundären Leiter (WS2$_1$, WS2$_2$, WS2$_3$, WS2$_4$) der zweiten Schaltung aus Silizium-Germanium, das mit Silizium umgeben ist, hergestellt sind, oder aus Silizium, das mit Siliziumoxid umgeben ist.

**Claims**

**1.** A photonic circuit (C1) comprising a structure of coupling to an outer device, the structure comprising a main waveguide (WP1) having a rectangular transverse cross-section and four secondary waveguides (WS1$_1$, WS1$_2$, WS1$_3$, WS1$_4$), each secondary waveguide (WS1$_1$, WS1$_2$, WS1$_3$, WS1$_4$) having a first portion substantially parallel to the main guide (WP1) arranged in the vicinity of the main guide (WP1) to perform an evanescent wave coupling between the main guide (WP1) and the secondary guide, the first portion extending in a second portion having an end opposite to the first portion defining a coupling surface of the secondary guide, emerging at the level of an external surface of the circuit, wherein the first portions of the four secondary guides (WS1$_1$, WS1$_2$, WS1$_3$, WS1$_4$) are, in transverse cross-section, arranged around the main guide (WP1) on the diagonals of the main guide.

**2.** The circuit of claim 1, wherein each secondary guide (WS1$_1$, WS1$_2$, WS1$_3$, WS1$_4$) has a tapered end on the side of its coupling surface.

**3.** The circuit of claim 1 or 2, wherein the coefficients of coupling between the main guide (WP1) and each of the secondary guides (WS1$_1$, WS1$_2$, WS1$_3$, WS1$_4$) are substantially identical.

**4.** The circuit of any of claims 1 to 3, wherein the first portions of the secondary guides (WS1$_1$, WS1$_2$, WS1$_3$, WS1$_4$) are substantially at an equal distance from the main guide (WP1).

5. The circuit of any of claims 1 to 4, wherein the maximum center-to-center distance between two secondary guides (WS1$_1$, WS1$_2$, WS1$_3$, WS1$_4$) at the level of their coupling surfaces is substantially equal to twice the radius of the light beam propagated by each secondary guide at the level of its coupling surface.

6. The circuit of any of claims 1 to 5, wherein along their first portions, the secondary guides (WS1$_1$, WS1$_2$, WS1$_3$, WS1$_4$) progressively widen to reach a maximum width at the level of their second portions.

7. The circuit of any of claims 1 to 6, wherein, along the first portions of the secondary guides, the main guide (WP1) progressively thins down.

8. The circuit of any of claims 1 to 7, wherein the main guide stops before the external surface of the circuit (C1).

9. The circuit of any of claims 1 to 8, wherein the main waveguide (WP1) and the secondary waveguides (WS1$_1$, WS1$_2$, WS1$_3$, WS1$_4$) are made of silicon-germanium and are surrounded with silicon.

10. The circuit of any of claims 1 to 8, wherein the main waveguide (WP1) and the secondary waveguides (WS1$_1$, WS1$_2$, WS1$_3$, WS1$_4$) are made of amorphous silicon and are surrounded with silicon oxide.

11. The circuit of claim 10, wherein the main waveguide (WP1) forms an extension of a waveguide (W) internal to the circuit (C1), the internal waveguide (W) being made of crystal silicon.

12. The circuit of any of claims 1 to 8, comprising an integrated laser source, the main waveguide (WP1) being coupled to the laser source.

13. A device comprising first (C1) and second (C2) photonic circuits according to any of claims 1 to 12, wherein the coupling surfaces of the four secondary guides (WS1$_1$, WS1$_2$, WS1$_3$, WS1$_4$) of the first circuit (C1) are respectively placed against the coupling surfaces of the four secondary guides (WS2$_1$, WS2$_2$, WS2$_3$, WS2$_4$) of the second circuit (C2).

14. The device of claim 13, wherein at least one of the secondary guides (WS1$_1$, WS1$_2$, WS1$_3$, WS1$_4$) of the first circuit (C1) is made of a different material than the corresponding secondary guide (WS2$_1$, WS2$_2$, WS2$_3$, WS2$_4$) of the second circuit (C2).

15. The device of claim 13 or 14, wherein:

the first circuit integrates a laser source made up of III-V semiconductor materials, the main guide (WP1) of the first circuit being coupled to said laser source; and
the main guide (WP2) and the secondary guides (WS2$_1$, WS2$_2$, WS2$_3$, WS2$_4$) of the second circuit are made of silicon-germanium surrounded with silicon, or of silicon surrounded with silicon oxide.

Fig 1A

Fig 1B

Fig 2A

Fig 2B

Fig 2C

Fig 2D

Fig 3A

Fig 3B

Fig 4

α

503

503
501

**Fig 5A**

WS1₄

WS1₃

501

WS1₃    WS1₄

501

**Fig 5B**

WS1₄

WS1₃

505

WS1₃    WS1₄

505
501

**Fig 5C**

WS1₄

WS1₃

507

WS1₃    WS1₄

507
505
501

**Fig 5D**

Fig 5E

Fig 5F

Fig 5G

Fig 5H

WS1$_2$  WP1  WS1$_1$

513

WS1$_1$

WP1

513

509

505

WS1$_2$

501

WS1$_3$  WS1$_4$

**Fig 5I**

α

605

W

β —————————————————————— β

W

605

603

601

α

605

W

603

601

**Fig 6A**

Fig 6B

Fig 6C

WP1

α

705

β—β

α

WP1

705

703

701

WP1

705

703

701

**Fig 7A**

WP1

707a

705

WP1

707b

707b

WP1

707a

705

703

701

WP1

705

703

701

707b

707a

**Fig 7B**

WP1    707a
709

WP1

705

703

701

**Fig 7C**

709  707b  WP1  707a
705
703
701

WP1    715    WS1₁
709

715    707b

WP1

705

703

701

709  WS1₂  WP1  WS1₁
715
713
711
705
703
701

WS1₃    WS1₄

**Fig 7D**

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 2013170807 A, Hatori Nobuaki

**Littérature non-brevet citée dans la description**

- **B. BEN BAKIR et al.** Electrically driven hybrid Si/III-V Fabry-Pérot lasers based on adiabatic mode transformers. *Opt Exp,* 2011, vol. 19, 10317
- **X. SUN et al.** Adiabaticity criterion and the shortest adiabatic mode transformer in a coupled-waveguide system. *Opt let,* 2009, vol. 34, 280
- **P. KARIOJA et al.** Diode-laser-to-waveguide butt coupling. *Applied optics,* 1996, vol. 35, 404
- **G. ROELKENS et al.** Efficient Silicon-on-Insulator Fiber Coupler Fabricated Using 248-nm-Deep UV Lithography. *Photonics technology letters,* 2005, vol. 17, 2613